# EUROPÄISCHE PATENTSCHRIFT

(11) **EP 2 543 241 B1**
(45) Veröffentlichungstag und Bekanntmachung des Hinweises auf die Patenterteilung: **26.11.2014**
(21) Anmeldenummer: 11703861.2
(22) Anmeldetag: 09.02.2011
(51) Int. Cl.: H05K 7/20

(54) **VERFAHREN UND VORRICHTUNG ZUM REGELN EINES AN EINEM SCHALTSCHRANK ANGEBRACHTEN KÜHLGERÄTES**
METHOD AND APPARATUS FOR REGULATING A COOLING DEVICE FITTED TO A SWITCHGEAR CABINET
PROCÉDÉ ET DISPOSITIF DE RÉGLAGE D'UN APPAREIL RÉFRIGÉRANT APPLIQUÉ CONTRE UNE ARMOIRE ÉLECTRIQUE

(30) Priorität: 01.03.2010 DE 102010009776
(43) Veröffentlichungstag der Anmeldung: 09.01.2013
(73) Patentinhaber: RITTAL GmbH & Co. KG, 35745 Herborn (DE)
(72) Erfinder: SCHNEIDER, Ralf, 35745 Herborn (DE); SCHOLL, Michael, 35745 Herborn (DE); WAGNER, Steffen, 57299 Burbach (DE); MAAGE, Michael, 35630 Ehringshausen (DE)
(74) Vertreter: Tönhardt, Marion
(86) Internationale Anmeldenummer: PCT/EP2011/051856
(87) Internationale Veröffentlichungsnummer: WO 2011/107329

(56) Entgegenhaltungen:
- DE-A1- 4 114 700
- DE-A1- 4 441 494
- DE-A1- 10 013 039
- US-A- 4 356 961

## Beschreibung

Die Erfindung bezieht sich auf ein Verfahren zum Regeln eines in oder an einem Schaltschrank angebrachten Kühlgerätes mittels einer Regelungseinrichtung, bei dem die Temperatur der Schaltschrankinnenluft erfasst wird und ein dieser zugeordneter Innenlüfter zum Erzeugen eines Innenluftstroms durch einen Verdampfer und zum bereitstellen von Kühlluft zum Danerbetrieb eingeschaltet wird, wenn die erfasste Temperatur der Schaltschrankinnenluft eine obere Vorgabetemperatur überschreitet, und ausgeschaltet wird, wenn die erfasste Temperatur eine untere Vorgabetemperatur unterschreitet, und auf eine Vorrichtung zur Durchführung des Verfahrens.

Ein Kühlgerät auf diese Weise zu regeln, ist aus der DE 100 13 039 A1 bekannt.

Ein derartiges Verfahren zum Regeln eines an einem Schaltschrank angebrachten Kühlgerätes und eine Vorrichtung zur Durchführung des Verfahrens sind auch in der DE 44 13 128 C2 angegeben. Mit dem Kühlgerät wird die Schaltschrankinnenluft, die sich beim Betrieb von Verlustwärme abgebenden Einbaukomponenten erhöht, unter einer für die Einbaukomponenten nachteiligen Temperatur gehalten und die im Schaltschrank erzeugte Verlustwärme aus dem Schaltschrank abgeführt. Das Kühlgerät hat mehrere Kreisläufe, die im Zusammenspiel die Schaltschrankinnenluft abkühlen. Ein Innenluftkreislauf wird über einen Innenlüfter des Kühlgeräts angetrieben. Im Inneren des Kühlgerätes sitzt ein Temperatursensor, der die angesaugte warme Schaltschrankinnenluft misst. In Abhängigkeit von einer eingestellten Solltemperatur werden ein Kältekreislauf mit einem fluiden Kältemittel und ein Außenluftkreislauf zu- oder abgeschaltet. Dabei wird die Wärmeenergie der Schaltschrankinnenluft in einem Verdampfer von dem Kältemittel des Kältekreislaufes aufgenommen. Das Kältemittel wird dann von einem Kompressor stark komprimiert, wodurch es in einem Verflüssiger ein höheres Temperaturniveau erreicht als die Umgebungsluft. Dadurch kann die in dem Kältemittel transportierte Wärmeenergie an den Außenluftkreislauf, der durch einen Außenlüfter angetrieben wird, abgegeben werden. Um die Innentemperatur des Schaltschrankes bzw. die Schaltschrankinnenluft zu regeln, wird das Kühlgerät nur intervallweise in Betrieb genommen, wobei der Kompressor und der Außenlüfter temperaturabhängig über eine geräteinterne Regelungseinrichtung intervallweise zu- und abgeschaltet werden. Für die Temperaturmessung im Kühlgerät wird die Schaltschrankinnenluft mittels des Innenlüfters über einen Temperatursensor geführt, wobei der Betrieb des Innenlüfters nicht unerheblich zum Energieverbrauch beiträgt.

Weitere Kühlgeräte für Schaltschränke zeigen die DE 10 2006 051 904 A1, die DE 199 12 029 C2 und die DE 199 51 921 C2 , wobei unterschiedliche Anordnungen an einem Schaltschrank gezeigt sind.

Gemäß der DE 44 41 494 A1 ist für die Regelung vorgesehen, dass eine Mindestlaufzeit des Lüfters eingehalten werden soll, nachdem er in einer ersten oder zweiten Drehzahlstufe eingeschaltet wurde. Die US 4,356,961 A verwendet Mindestzeitdauern für Kompressoren, nachdem sie in verschiedenen Phasen nacheinander ein- oder ausgeschaltet wurden. Bei der DE 41 14 700 A1 sorgen zwei Verzögerungsglieder dafür, dass das Ein- bzw. Ausschalten einer Leistungsstufe der Kompressoreinheit erst nach einer bestimmten Zeit seit dem Ändern der Temperaturkurve von fallend zu steigend und umgekehrt erfolgt.

Der Erfindung liegt die Aufgabe zugrunde, ein Verfahren der eingangs genannten Art bereit zu stellen, mit dem ein sparsamerer Betrieb bei zuverlässiger Kühlung erreicht wird, und eine entsprechende Vorrichtung zu schaffen.

Diese Aufgabe wird mit den Merkmalen des Anspruches 1 bzw. des Anspruches 3 gelöst. Hierbei ist vorgesehen, dass nach Abschalten des Innenlüfters infolge Unterschreitens der unteren Vorgabetemperatur gleichzeitig eine Zeitnahme gestartet wird und der Innenlüfter nach einer vorgegebenen ersten Zeitdauer für eine vorgegebene zweite Zeitdauer eingeschaltet und danach wieder abgeschaltet wird, wenn die obere Vorgabetemperatur von der erfassten Temperatur unterschritten bleibt, solange die zweite Zeitdauer läuft, dass diese intermittierende zeitgesteuerte Betriebsweise des Innenlüfters zyklisch wiederholt wird, bis die obere Vorgabetemperatur überschritten wird, wonach der Innenlüfter wieder im Dauerbetrieb betrieben wird, und dass die Zeitnahme und die intermittierende zeitgesteuerte Betriebsweise des Innenlüfters erneut gestartet werden, wenn die untere Vorgabetemperatur wieder unterschritten wird.

Bei der Vorrichtung ist vorgesehen, dass eine Zeitsteuereinheit vorhanden ist, mittels der eine Zeitnahme auslösbar ist, wenn die erfasste Temperatur die untere Vorgabetemperatur unterschreitet oder der Innenlüfter ausgeschaltet wird, und eine intermittierende zeitgesteuerte Betriebsweise unter Einschaltung des Innenlüfters nach einer ersten Zeitdauer für eine zweite Zeitdauer erfolgt, solange die obere Vorgabetemperatur nicht überschritten ist.

Mit diesen Maßnahmen wird zuverlässig eine genügende Umwälzung der Schaltschrankinnenluft sichergestellt und ein für die Kühlung von Einbaukomponenten und deren sicheren Betrieb zuträgliches Temperaturniveau gewährleistet.

Zu einem zuverlässigen Betrieb des Kühlgerätes tragen die Maßnahmen bei, dass ein Kompressor und ein Außenlüfter des Kühlgerätes während der intermittierenden zeitgesteuerten Betriebsweise eingeschaltet bleiben, solange deren Einschaltung über die Regelungseinrichtung vorgegeben wird.

Eine vorteilhafte Ausgestaltung der Vorrichtung besteht darin, dass die Zeitsteuereinheit Teileiner mikroprosessor-steuerung oder mikrocomputerschaltung ist und dass die zeitgesteuerte Betriebsweise in der Zeitsteuereinheit durch ein Programm vorgegeben ist.

Die Erfindung wird nachfolgend anhand von Ausführungsbeispielen unter Bezugnahme auf die Zeichnungen näher erläutert. Es zeigen:
- Fig. 1: eine schematische Darstellung eines Schaltschranks mit daran angebrachtem Kühlgerät und dabei vorliegenden Luftströmungsverhältnissen,
- Fig. 2: ein Beispiel für eine Betriebsweise eines Innenlüfters und
- Fig. 3: ein bei vorliegender Erfindung bevorzugtes Ausführungsbeispiel für eine Betriebsweise des Innenlüfters.

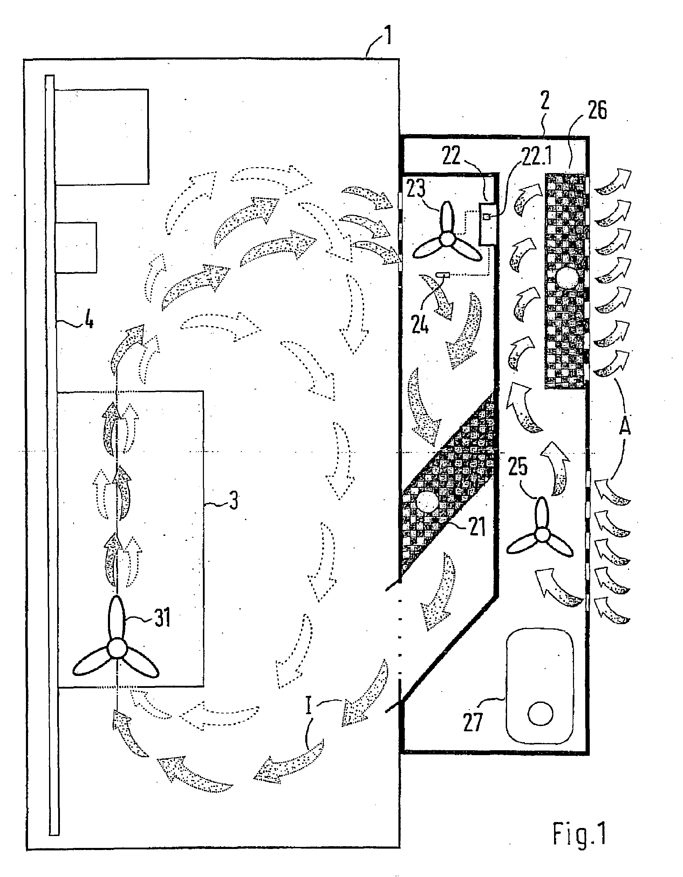

Fig. 1 zeigt in schematischer Ansicht einen Schaltschrank 1 mit einem an dessen Rückwand angebauten Kühlgerät 2. In dem Schaltschrank 1 sind auf einer Montageplatte 4 Einbaukomponenten 3 angebracht, die Verlustwärme erzeugen und mittels des Kühlgerätes 2 über einen Innenluftkreislauf I gekühlt werden.

In dem Kühlgerät 2 sind in einem mit dem Schaltschrankinnenraum über Strömungsöffnungen in Strömungsverbindung gebrachten ersten Teilraum ein Innenlüfter 23 im oberen Bereich des Teilraums und stromab desselben ein Verdampfer 21 angeordnet. Ferner umfasst das Kühlgerät 2 eine Regelungseinrichtung 22, eine Zeitsteuereinheit 22.1 und einen in dem ersten Teilraum in der Nähe des lnnenlüfters 23 angeordneten Temperatursensor 24 zum Erfassen der Temperatur TI der aus dem Schaltschrankinnenraum in den ersten Teilraum einströmenden Schaltschrankinnenluft.

In dem Kühlgerät 2 ist auch ein Kältekreislauf für ein fluides Kältemittel gebildet sowie ein Außenluftkreislauf A, bei dem über einen in einem zweiten Teilraum des Kühlgerätes 2 in dessen unterem Bereich angeordneten Außenlüfter 25 Außenluft über Außenluftöffnungen angesaugt und nach Durchströmen eines Verflüssigers 26 nach außen wieder abgegeben wird. Der Kältekreislauf für das Kältemittel umfasst den Verdampfer 21, in dem die Wärmeenergie der Schaltschrankinnenluft von dem durch diesen fließenden Kältemittel aufgenommen wird, sowie einen Kompressor 27, vorliegend im unteren Bereich des zweiten Teilraums, durch den das Kältemittel stark komprimiert wird, wodurch es in dem weiterhin im Kältekreislauf liegenden Verflüssiger 26 ein höheres Temperaturniveau erreicht als die Umgebungsluft. Dadurch wird die in dem Kältemittel von dem Schaltschrankinnenraum her transportierte Wärmeenergie an den Außenluftkreislauf A abgegeben, der durch den Außenlüfter 25 angetrieben wird.

In Abhängigkeit einer eingestellten Solltemperatur bzw. Vorgabetemperatur werden der Kältekreislauf und der Außenluftkreislauf A zu- oder abgeschaltet, um Temperaturgrenzwerte im Schaltschrank einzuhalten. Hierzu dient die Regelungseinrichtung 22 des Kühlgerätes 2, über die die temperaturabhängige Zu- und Abschaltung des Kompressors 27 und des Außenlüfters 25 erfolgen. Für einen zuverlässigen Kühlbetrieb ist dabei eine genaue Temperaturmessung der Schaltschrankinnenluft erforderlich. Diese wird über den Temperatursensor 24 vorgenommen.

Der in Fig. 1 gezeigte lnnenfuftkreislauf I durch den ersten Teilraum des Kühlgerätes 2 ergibt sich bei Betrieb des Innenlüfters 23, während bei abgeschaltetem Innenlüfter 23 innerhalb des Schaltschranks ein anderer Innenluftkreislauf I' vorliegt, bei dem allenfalls ein geringfügiger Strom der Schaltschrankinnenluft durch das Kühlgerät 2 auftritt. Die Luftströmung in dem Schaltschrankinnenraum kann noch durch Gerätelüfter 31 der Einbaukomponenten 3 unterstützt sein. Im betriebslosen Zustand des lnnenlüfters 23 kann sich im Bereich des Temperatursensors 24 infolge schlechter Luftdurchmischung eine ungenaue Temperaturmessung der im Bereich der zu kühlenden Einbaukomponenten 3 vorliegenden Lufttemperatur ergeben.

Demnach erscheint es aus Sicht einer genauen Temperaturmessung geboten, den Innenlüfter 23 ständig in Betrieb zu halten. Mit einem andauernden Betrieb ist allerdings ein entsprechend hoher Verschleiß und Energieverbrauch verbunden.

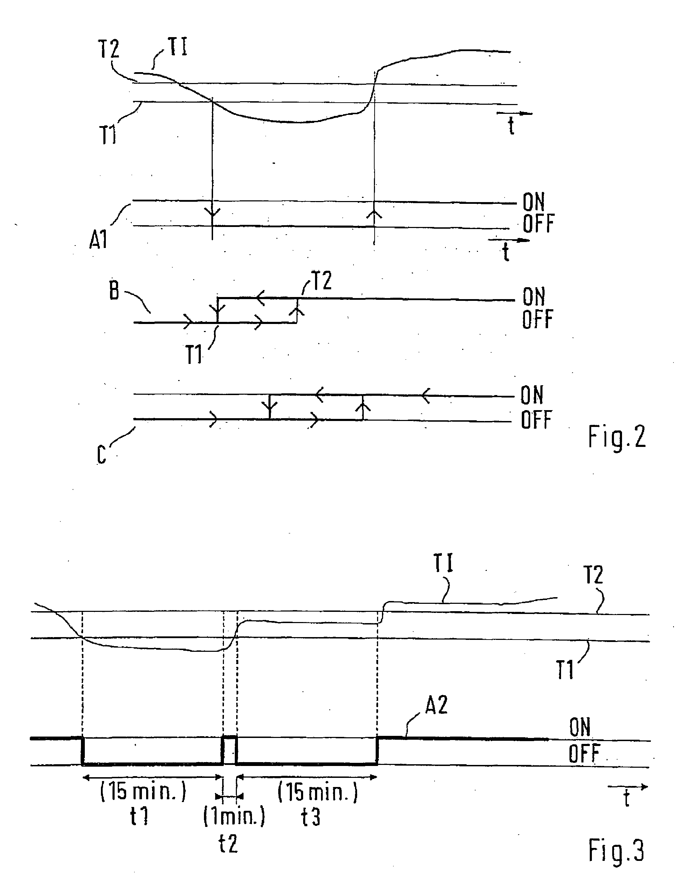

Fig. 2 zeigt ein Ausführungsbeispiel, bei dem der Innenlüfter 23 temperaturgesteuert ein- und ausgeschaltet wird. In dem oberen Teilbild ist der Innenlüfterbetriebszustand A1 über der Zeit t dargestellt sowie auch der Verlauf der Innenlufttemperatur TI über der Zeit t. Liegt die Innenlufttemperatur TI über einer oberen Vorgabetemperatur T2 (z. B. -5° C), so befindet sich der Innenlüfter im eingeschalteten Zustand und wird erst abgeschaltet, wenn die Innenlufttemperatur TI unter eine (unter der oberen Vorgabetemperatur liegende) untere Vorgabetemperatur T1 (z. B. -10° C) fällt. Steigt die Innenlufttemperatur TI bei betriebslosem Zustand des Kühlgerätes 2 wieder an und überschreitet die obere Vorgabetemperatur T2, so wird der Innenlüfter 23 wieder eingeschaltet und auch der Kühlbetrieb aktiviert.

Die mittlere Darstellung in Fig. 2 zeigt den Betrieb des Innenlüfters 23 in Abhängigkeit von der erfassten Temperatur. Demnach wird der Innenlüfter 23 aus dem ausgeschalteten in den eingeschalteten Zustand gebracht, wenn die erfasste Temperatur TI der oberen Vorgabetemperatur T2 entspricht und von dem eingeschalteten in den ausgeschalteten Zustand gebracht, wenn die erfasste Temperatur TI die untere Vorgabetemperatur T1 unterschreitet.

In der unteren Darstellung der Fig. 2 ist der Betrieb des Kompressors 27 und des Außenlüfters 25 in Abhängigkeit der Innentemperatur des Schaltschranks dargestellt. Auch hierbei ist eine Hysterese vorgesehen, wobei der Kompressor 27 und der Außenlüfter 25 aus dem ausgeschalteten Zustand in den eingeschalteten Zustand gebracht werden, wenn eine höhere Temperatur (oberhalb der oberen Vorgabetemperatur T2) erreicht wird, und von dem eingeschalteten Zustand in den ausgeschalteten Zustand, wenn eine niedrigere Temperatur, vorliegend z. B. unterhalb der oberen Vorgabetemperatur T2 und oberhalb der unteren Vorgabetemperatur T1, erreicht wird.

Bei dieser temperaturgesteuerten Betriebsweise ist demnach die Temperaturregelung der Innenlufttemperatur des Schaltschranks insbesondere im Bereich der Einbaukomponenten mit Unsicherheiten behaftet. Es könnte daran gedacht werden, den Innenlüfter 23 mittels Temperatursignalen zu steuern, die von einem weiteren Temperatursensor kommen, die z. B. in der Nähe der Einbaukomponente 3 angeordnet ist.

Vorliegend wird jedoch dem temperaturgesteuerten Regelungsbetrieb eine zeitgesteuerte Betriebsweise des Innenlüfters überlagert, wie in Fig. 3 dargestellt. Unterschreitet die gemessene Temperatur TI der Innenluft von einer über der oberen Vorgabetemperatur T2 liegenden Temperatur kommend die untere Vorgabetemperatur T1, so wird der Innenlüfter 23 von dem eingeschalteten Zustand in den ausgeschalteten Zustand versetzt. Gleichzeitig wird eine Zeitnahme in Gang gesetzt und ein Zeitsignal von der Zeitsteuereinheit 22.1 bereitgestellt. Nach einer ersten Zeitdauer t1 (von z. B. 15 Minuten) wird der Innenlüfter 23 für eine zweite Zeitdauer t2 (von z. B. 1 Minute) eingeschaltet. Hierbei erhöht sich die erfasste Temperatur TI im Bereich des Temperatursensors 24 zwar von einem Wert unterhalb der unteren Vorgabetemperatur T1 auf einen Wert oberhalb derselben, bleibt (bei dem gezeigten Beispiel) jedoch noch unterhalb der oberen Vorgabetemperatur T2. Demnach wird der Innenlüfter 23 noch nicht temperaturgesteuert eingeschaltet, sondern zeitgesteuert für eine dritte Zeitdauer t3, die der ersten Zeitdauer t1 entspricht, wieder ausgeschaltet. Nach Ablauf der dritten Zeitdauer t3 (von z. B. 15 Minuten) wird der Innenlüfter 23 wieder eingeschaltet, wodurch die nun erfasste Innenfufttemperatur TI die obere Vorgabetemperatur T2 überschreitet und dadurch der Innenlüfter 23 temperaturgesteuert eingeschaltet bleibt. Den Einschaltzustand behält der Innenlüfter 23 dann solange bei, bis wiederum die untere Vorgabetemperatur T1 unterschritten wird. Dann beginnt die zeitgesteuerte Betriebsweise unter Start der Zeitnahme von Neuem, wie vorstehend beschrieben, bis wiederum die obere Vorgabetemperatur T2 überschritten wird.

Durch die zyklische intermittierende Betriebsweise des Innenlüfters 23 wird ein zuverlässiger Kühlbetrieb gewährleistet, da im Bereich des Temperatursensors 24 die Innentemperatur des Schaltschranks infolge der zeitgesteuerten Betriebsweise des Innenlüfters 23 relativ zuverlässig erfasst wird. Dabei kann die Zuverlässigkeit mehr oder weniger hoch gewählt werden, indem die erste Zeitdauer t1 und die zweite Zeitdauer t2 des zyklischen Betriebs jeweils vorliegenden Anforderungen angepasst werden.

Die zeitgesteuerte Betriebsweise ist vorteilhaft durch ein Programm vorgegeben, wobei die Zeitsteuereinheit 22.1 Teil einer Mikroprozessorsteuerung oder Mikrocomputerschaltung sein kann. Der zeitgesteuerte Betrieb des Innenlüfters 23 kann unmittelbar durch das Zeitsteuersignal der Zeitsteuereinheit 22.1 erfolgen oder mittelbar durch dieses über andere Schaltungskomponenten.

## Patentansprüche

1. Verfahren zum Regeln eines in oder an einem Schaltschrank (1) angebrachten Kühlgerätes (2) mittels einer Regelungseinrichtung (22), bei dem die Temperatur (TI) der Schaltschrankinnenluft (I, I') erfasst wird und ein dieser zugeordneter Innenlüfter (23) zum Erzeugen eines Innenluftstroms durch einen Verdampfer (21) und zum Bereitstellen von Kühlluft zum Danerbetrieb eingeschaltet wird, wenn die erfasste Temperatur (TI) der Schaltschrankinnenluft eine obere Vorgabetemperatur (T2) überschreitet, und ausgeschaltet wird, wenn die erfasste Temperatur (TI) eine untere Vorgabetemperatur (T1) unterschreitet,
**dadurch gekennzeichnet,**
**dass** nach Abschalten des Innenlüfters (23) infolge Unterschreitens der unteren Vorgabetemperatur (T1) gleichzeitig eine Zeitnahme gestartet wird und der Innenlüfter (23) nach einer vorgegebenen ersten Zeitdauer (t1) für eine vorgegebene zweite Zeitdauer (t2) eingeschaltet und danach wieder abgeschaltet wird, wenn die obere Vorgabetemperatur (T2) von der erfassten Temperatur (TI) unterschritten bleibt, solange die zweite Zeitdauer (t2) läuft,
**dass** diese intermittierende zeitgesteuerte Betriebsweise des Innenlüfters (23) zyklisch wiederholt wird, bis die obere Vorgabetemperatur (T2) überschritten wird, wonach der Innenlüfter (23) gleichzeitig im Dauerbetrieb betrieben wird, und
**dass** die Zeitnahme und die intermittierende zeitgesteuerte Betriebsweise des Innenlüfters (23) erneut gestartet werden, wenn die untere Vorgabetemperatur wieder (T1) unterschritten wird.

2. Verfahren nach Anspruch 1,
**dadurch gekennzeichnet,**
**dass** ein Kompressor (27) und ein Außenlüfter (25) des Kühlgerätes (2) während der intermittierenden zeitgesteuerten Betriebsweise eingeschaltet bleiben, solange die Einschaltung über die Regelungseinrichtung (22) vorgegeben wird.

3. Vorrichtung zur Durchführung des Verfahrens nach Anspruch 1 oder 2, mit einem in oder an einem Schaltschrank (1) angeordneten Kühlgerät (2), das einen Innenlüfter (23) zum Erzeugen eines Innenluftstroms (I) aufweist, welcher den Schaltschrankinnenraum mit darin angeordneten, Verlustwärme erzeugenden Einbaukomponenten (3) und einen mit dem Schaltschrankinnenraum in Strömungsverbindung gebrachten Teilraum des Kühlgerätes (2) mit einem darin angeordneten Verdampfer (21) in einem Kreislauf durchströmt, mit einem Kühlmittelkreislauf, wobei das Kühlmittel einen Kompressor (27) durchströmt und in einem in einem Außenluftkreislauf (A) angeordneten Verflüssiger (26) gekühlt wird, und mit einer Regelungseinrichtung (22), mit der der Innenlüfter (23) eingeschaltet wird, wenn eine in dem Innenluftstrom (I) erfasste Temperatur (TI) eine obere Vorgabetemperatur (T2) überschreitet, und ausgeschaltet wird, wenn die erfasste Temperatur (TI) eine untere Vorgabetemperatur (T1) unterschreitet,
**dadurch gekennzeichnet,**
**dass** eine Zeitsteuereinheit (22.1) vorhanden ist, mittels der eine Zeitnahme auslösbar ist, wenn die erfasste Temperatur (TI) die untere Vorgabetemperatur (T1) unterschreitet oder der Innenlüfter (23) ausgeschaltet wird, und eine intermittierende zeitgesteuerte Betriebsweise unter Einschaltung des Innenlüfters (23) nach einer ersten Zeitdauer (t1) für eine zweite Zeitdauer (t2) erfolgt, solange die obere Vorgabetemperatur (T2) nicht überschritten ist.

4. Vorrichtung nach Anspruch 3,
**dadurch gekennzeichnet, dass** die Zeitsteuereinheit (22.1) Teil einer mikroprosessorsteuerung oder mikrocomputerschaltung ist und
dass die zeitgesteuerte Betriebsweise in der Zeitsteuereinheit (22.1) durch ein Programm vorgegeben ist.

## Claims

1. A method for regulating a cooling device (2) fitted in or to a switchgear cabinet (1), by means of a regulating device (22), wherein the temperature (TI) of the switchgear cabinet interior air (I, I') is detected and an interior fan (23) assigned thereto for generating an interior air flow through an evaporator (21) and for providing cooling air for continuous operation is switched on if the detected temperature (TI) of the switchgear cabinet interior air exceeds an upper setpoint temperature (T2), and is switched off if the detected temperature (TI) falls below a lower setpoint temperature (T1), **characterized in that**
after the interior fan (23) has been switched off owing to the lower setpoint temperature (T1) being undershot, a time keeping is started simultaneously and the interior fan (23) is switched on after a predetermined first time duration (t1) for a second predetermined time duration (t2) and is switched off again if the detected temperature (TI) still falls below the upper setpoint temperature (T2), as long as the second time duration (t2) proceeds,
said intermittent time-controlled mode of operation of the interior fan (23) is cyclically repeated until the upper setpoint temperature (T2) is exceeded after which the interior fan (23) is operated simultaneously in continued operation, and
the time keeping and the intermittent time-controlled mode are started anew, if the lower setpoint temperature (T1) is again undershot.

2. The method of claim 1, **characterized in that** a compressor (27) and an external fan (25) of the cooling device (2) remain switched on during the intermittent time-controlled mode of operation, as long as switching on is predetermined by the regulation device (22).

3. An apparatus for performing the method of claim 1 or 2, comprising a cooling device (2) fitted in or to a switchgear cabinet (1) and including an interior fan (23) for generating an interior air flow (I) which circulates through the switchgear interior housing build-in components (3) which generate dissipated heat and through a subspace of the cooling device in flow communication with the switchgear interior and housing an evaporator, comprising a coolant circuit, wherein the coolant flows through a compressor (27) and is cooled in a condenser (26) arranged in an ambient air circuit (A), and comprising a regulating device (22) by which the interior fan (23) is switched on if the detected temperature (TI) in the interior air flow (I) exceeds an upper setpoint temperature (T2), and is switched off if the detected temperature (TI) falls below a lower setpoint temperature (T1),
**characterized in that**
a time control unit (22.1) is included, by which a time keeping may be triggered if the detected temperature (TI) undershots the lower setpoint temperature (T1) or the interior fan (23) is switched off, and an intermittent time-controlled operation by switching on the interior fan (23) after a predetermined first time duration (t1) for a second predetermined time duration (t2) as long as the upper setpoint temperature (T2) is not exceeded is performed.

4. The apparatus of claim 3,
**characterized in that**
the time control unit (22.1) forms part of a microprocessor control or microcomputer circuit, and the time controlled operation within the time controlled unit (22.1) is predetermined by a program.

## Revendications

1. Procédé permettant de régler un appareil de refroidissement (2) installé dans ou sur une armoire électrique (1) au moyen d'un dispositif de réglage (22), dans lequel la température (TI) de l'air à l'intérieur de l'armoire électrique (I, I') est détectée et un ventilateur intérieur (23) y afférent est activé de façon continue afin de produire un flux d'air intérieur au travers d'un évaporateur (21) et de fournir de l'air frais lorsque la température (TI) détectée de l'air à l'intérieur de l'armoire électrique dépasse une température de consigne supérieure (T2) et il est arrêté lorsque la température (TI) détectée descend en dessous d'une température de consigne inférieure (T1), **caractérisé**
**en ce qu'**après l'arrêt du ventilateur intérieur (23) en raison de l'arrivée en dessous de la température de consigne inférieure (T1),un chronométrage est lancé simultanément et le ventilateur intérieur (23) est activé après une première durée prédéfinie (t1) pendant une deuxième durée prédéfinie (t2), puis à nouveau arrêté si la température (TI) détectée reste en dessous de la température de consigne supérieure (T2) pendant que la deuxième durée (t2) s'écoule,
**en ce que** ce fonctionnement intermittent commandé par temporisation du ventilateur intérieur (23) est répété de façon cyclique jusqu'à ce que la température de consigne supérieure (T2) soit dépassée, après quoi le ventilateur intérieur (23) est à nouveau activé de façon continue, et
**en ce que** le chronométrage et le fonctionnement intermittent commandé par temporisation du ventilateur intérieur (23) sont recommencés lorsque la température (TI) détectée descend à nouveau en dessous de la température de consigne inférieure (T1).

2. Procédé selon la revendication 1,
**caractérisé**
**en ce qu'**un compresseur (27) et un ventilateur extérieur (25) de l'appareil de refroidissement (2) restent activés pendant le fonctionnement intermittent commandé par temporisation aussi longtemps que l'activation est prédéfinie par le biais du dispositif de réglage (22).

3. Dispositif permettant de mettre en oeuvre le procédé selon la revendication 1 ou 2, comprenant un appareil de refroidissement (2) agencé dans ou sur une armoire électrique (1), qui présente un ventilateur intérieur (23) destiné à produire un flux d'air intérieur (I) qui circule dans un circuit à travers l'espace intérieur de l'armoire électrique, comprenant des composants intégrés (3) produisant une chaleur perdue agencés dans celle-ci, et un espace partiel de l'appareil de refroidissement (2), comprenant un évaporateur (21) agencé dans celui-ci, mis en liaison de circulation avec l'espace intérieur de l'armoire électrique, comprenant un circuit de fluide réfrigérant, étant entendu que le fluide réfrigérant circule à travers un compresseur (27) et est refroidi dans un condenseur (26) agencé dans un circuit d'air extérieur (A), et comprenant un dispositif de réglage (22) avec lequel le ventilateur intérieur (23) est activé lorsqu'une température (TI) détectée dans le flux d'air intérieur (I) dépasse une température de consigne supérieure (T2) et il est arrêté lorsque la température (TI) détectée descend en dessous d'une température de consigne inférieure (T1),
**caractérisé**
**en ce qu'**il est prévu une unité de commande par temporisation (22.1) au moyen de laquelle un chronométrage peut être déclenché lorsque la température (TI) détectée descend en dessous de la température de consigne inférieure (T1) ou que le ventilateur intérieur (23) est arrêté, et un fonctionnement intermittent commandé par temporisation se produit, avec l'activation du ventilateur intérieur (23) après une première durée (t1) pendant une deuxième durée (t2), aussi longtemps que la température de consigne supérieure (T2) n'est pas dépassée.

4. Dispositif selon la revendication 3,
**caractérisé**
**en ce que** l'unité de commande par temporisation (22.1) fait partie d'une commande par microprocesseur ou d'une commutation par microordinateur, et
**en ce que** le fonctionnement commandé par temporisation est prédéfini par un programme dans l'unité de commande par temporisation (22.1).
